# EUROPEAN PATENT APPLICATION

(11) **EP 1 462 543 A1**
(43) Date of publication of application: **29.09.2004**
(21) Application number: 04251810.0
(22) Date of filing: 26.03.2004
(51) Int. Cl.: C23C 16/50, C23C 16/455, C23C 16/40

(54) **Film-forming method for forming metal oxide on substrate surface**

(30) Priority: 26.03.2003 JP 2003085145
(71) Applicant: ANELVA CORPORATION, Fuchu-shi, Tokyo 183-8508 (JP)
(72) Inventor: Kumagai, Akira, c/o Anelva Corporation, Tokyo 183-8508 (JP)
(74) Representative: Lyndon-Stanford, Edward Willoughby Brooke

(57) **Abstract**

A film-forming method includes the steps of introducing oxygen radicals and an organic raw material gas containing a metal element into a vacuum container 12, and reacting the organic raw material gas with the oxygen radicals, thereby forming a metal oxide film on a surface of a substrate 11 disposed in the vacuum container.

## Description

### BACKGROUND OF THE INVENTION

### Field of the Invention

The present invention relates to a film-forming method for a semiconductor device. More specifically, the present invention relates to a film-forming method for a semiconductor device which is used for forming a metal oxide filmon a surface of a semiconductor substrate such as a silicon substrate.

### Description of the Related Art

HfO₂ is one of metal oxides whose high dielectric constant has been watched with keen interest. As a method of forming a capacitative insulating film having high dielectric constant such as a HfO₂ film, the chemical vapor deposition method (which will be referred to as the "CVD method" hereinafter) has been keenly studied because the CVD method enables forming a thin film having excellent step-coverage properties.

For example, Japanese Patent Application Laid-Open (JP-A) No. 11-163282 discloses a method of producing a super LSI semiconductor device such as DRAM (dynamic random access memory) , which method comprising the steps of: selectively forming a thin W (tungsten) film, by the CVD method, on a lower electrode surface formed by providing a rough-surface polysilicon film on amorphous silicon and then causing a chemical vapor (gas-phase) reaction of an organic raw material (an organic tantalum gas) with an oxidizing gas, thereby forming a capacitative insulating film; making the capacitative insulating film dense; and forming an upper electrode composed of a metal element, on the capacitative insulating film, thereby forming a capacitative element portion of the semiconductor device.

In the above-described invention, a highly dielectric film composed of a metal oxide selected from the group consisting of tantalum oxide, titanium oxide, niobium oxide, hafnium oxide and yttrium oxide is used as the capacitative insulating film.

Further, as a specific example of the above-described process of making the capacitative insulating film dense, there has been proposed a plasma treatment using a gas selected from the group consisting of oxygen (O₂) gas, dinitrogen monoxide (N₂O) gas, oxygen gas containing moisture (H₂O) and a combination of thereof.

Japanese Patent No. 2764472, which corresponds to U.S. Patent No.5,290,609, discloses, as a film-forming method for a semiconductor, in which a dielectric film made of a metal oxide film is formed on a surface of a semiconductor substrate, said method comprising the steps of: reacting a source gas containing an organic tantalum compound with hydrogen radical, so that tantalum is evenly deposited on the substrate surface; reacting the deposited tantalum with oxygen radical and oxidizing the tantalum; and repeating the aforementioned two steps, thereby forming a dielectric film constituted of laminated layers of tantalum oxide. In this invention, it suffices as long as the dielectric film includes laminated layers of tantalum oxide. For example, the dielectric film may be structured as a multi-layered film in which a tantalum oxide film and at least a portion of a metal oxide film having high dielectric constant, selected from the group consisting of zirconium oxide, titanium oxide, tungsten oxide, niobium oxide, hafnium oxide and yttrium oxide, are alternately laminated.

However, when the CVD method is employed as a method of forming a metal oxide film, for example, a capacitative insulating film having high dielectric constant as described above, since an organic liquid raw material is vaporized and used as a raw material gas for the CVD method, it is likely that carbon (C) derived from hydrocarbon groups, such as methyl and ethyl groups, contained in the raw material gas is easily incorporated, as intermediate products, into the metal oxide film as the final product. Further, in the CVD method in which oxidizing gas and a raw material gas are directly mixed with each other and the resulting product is continuously deposited, oxidizing gas and the raw material gas are generally reacted with each other in the gaseous phase and a product resulting therefrom is deposited. Therefore, a thin film in which oxygen is insufficient in stoichiometrical terms is likely to be formed, and as a result, the electrical characteristics such as dielectric constant tends to deteriorate.

Accordingly, in the case in which a capacitative insulating film having high dielectric constant, made of a metal oxide film, is formed according to the invention disclosed in JP-A No. 11-163282, there is the necessity of carrying out a plasma treatment process by an oxidizing gas, as a process after the film-forming process, in order to improve the quality of the film (such as electric properties, the degree at which the film has been made dense, and the like) , separately from the film-forming process which is involved with an oxidizing reaction by oxygen gas.

Further, in the method according to the invention disclosed in Japanese Patent No. 2764472, when a metal oxide film is formed by the CVD method, a film-forming process which is accompanied by an oxidizing reaction is not conducted from the beginning of the film forming process, and the oxidizing process is separately carried out after the film-forming process.

In short, in the CVD method, it is necessary to carry out the before described process which is different from the film-forming process separately after the film-forming process, in order to remove carbon from the film in a form of CO or CO₂ gas by supplying a sufficient amount of oxygen atoms to the film and produce a metal oxide film which has been less affected by carbon contamination and whose analyzed composition is similar to the stoichiometrical composition thereof.

### SUMMARY OF THE INVENTION

The present invention has been contrived in consideration of the problems described above. One object of the present invention is to provide a film-forming method primarily for a semiconductor device, in which method, when the CVD method is employed as a method of forming a metal oxide film such as a capacitative insulating film having high dielectric constant, unreacted intermediate products such as carbon (C) are less likely to be incorporated into the film; a metal oxide whose analyzed composition is similar to the stoichiometrical composition thereof can be produced by a single film-forming process, without necessity of carrying out an oxidizing process or the like after the film-forming process; and a thin film having, in terms of film quality, sufficiently small microcrystals whose crystal sizes are sufficiently even and a sufficiently flat surface after film formation can be formed.

In order to achieve the above-described object, one aspect of the present invention provides a film-forming method comprising the steps of introducing oxygen radials and an organic raw material gas containing a metal element into a vacuum container, and reacting the organic raw material gas with the oxygen radicals, thereby forming a metal oxide film on a surface of a substrate disposed in the vacuum container.

Further, another aspect of the present invention provides a film-forming method comprising the steps of introducing oxygen radicals and an organic raw material gas containing a metal element into a vacuum container such that the organic raw material gas and the oxygen radicals are for the first time brought into contact with each other in the vacuum container, and reacting the organic raw material gas with the oxygen radicals, thereby forming a metal oxide film on a surface of a substrate disposed in the vacuum container.

In each of the above-described film-forming embodiments of the present invention, the formation of a metal oxide film can be conducted by introducing the oxygen radicals and the organic raw material gas containing a metal element into a film-forming treatment space, respectively, by way of a plurality of injection holes, and reacting the organic raw material gas with the oxygen radicals in the film-forming treatment sapace, thereby forming a metal oxide film on the surface of the substrate disposed in the vacuum container, characterised in that said film-forming treatment space is defined in the vacuum container by the space between the substrate disposed in the vacuum container and a plurality of injection holes disposed to face said substrate.

In short, in an embodiment of the film-forming method proposed by the present invention, an organic raw material gas containing a metal element and oxygen radicals are directly introduced to a film-forming treatment space, which is defined above a surface of substrate disposed in a vacuum container, respectively. More specifically, the organic raw material gas containing a metal element and the oxygen radials are directly introduced to a film-forming treatment space,which is defined in a vacuum container and between a substrate disposed in the vacuum container and a plurality of injection holes disposed to face said substrate, respectively. The organic raw material gas containing a metal element and oxygen radicals, which are directly introduced to a film-forming treatment space each respectively as the before described, are reacted with each other in the film-forming treatment space, whereby a metal oxide film is formed on the surface of the substrate disposed in the film-forming treatment space.

It should be noted that "directly introducing an organic raw material gas containing a metal element and oxygen radicals, respectively, into a film-forming treatment space" represents introducing the organic rawmaterial gas containing a metal element and the oxygen radicals into the film-forming treatment space such that the organic raw material gas containing a metal element and the oxygen radicals are for the first time brought into contact with each other in the film-forming treatment space, in other words, such that the oxygen radicals and the organic raw material gas containing a metal element are reliably prevented from making any contact with each other before being introduced to the film-forming treatment space and the oxygen radicals and the organic raw material gas containing a metal element are brought into contact with each other for the first time in the film-forming treatment space.

Inthe above-described embodiments of the present invention, the following structures may be employed as the structure for introducing the respective oxygen radicals and organic raw material gas containing a metal element into the film-forming treatment space by way of a plurality of injection holes.

For example, the following structure of film forming system can be used. This film forming system for forming a thin film has a structure in which the inside of a vacuum container is partitioned to a plasma-generating space and a film-forming treatment space by a conductive partition plate disposed so as to face a substrate, and the plasma-generating space and the film-forming treatment space communicate with each other only by way of a plurality of through holes formed at the partition plate. In this structure, oxygen radicals are introduced into the film-forming treatment space byway of the plurality of through holes which correspond to the plurality of injection holes described above.

On the other hand, with regards to introduction of the organic raw material gas containing a metal element, a structure can be used, in which the organic raw material gas is first introduced into an inner space provided inside the partition plate, which inner space is separated from the plasma-generating space and communicates with the film-forming treatment space by way of a plurality of diffusion holes, and then introduced into the film-forming treatment space by way of the plurality of diffusion holes which correspond to the plurality of injection holes described above.

It is preferable that, when the organic raw material gas containing a metal element and the oxygen radicals are introduced into the film-forming treatment space by way of the plurality of injection holes, each of the oxygen radicals and the organic raw material gas containing a metal element is evenly injected over the entire surface of the substrate. Injecting the oxygen radicals and the organic raw material gas in such a manner is preferable for making the crystal size of a metal oxide film formed on the substrate surface sufficiently even at the entire substrate surface and making the microcrystallized surface after the film formation sufficiently flat.

With reference to the example described above, it is preferable that thepluralityof through holes for injecting oxygen radicals is formed at the partition plate such that the oxygen radicals are evenly injected over the entire region of the substrate surface provided to face the partition plate as described above. It is also preferable that the plurality of diffusion holes for injecting the organic raw material gas containing a metal element is formed at the partition plate such that the organic raw material gas is evenly injected over the entire region of the substrate surface provided to face the partition plate as described above. It is preferable that the dimension of the partition plate is the same or larger than that of the substrate.

In the film-forming method of the present invention described above, an example of the metal element contained in the organic raw material gas is selected from the group consisting of ruthenium, hafnium, titanium, tantalum, zirconium and aluminum.

According to the film-forming method of the present invention described above, it is made possible, when the CVD method is employed as a method of forming a metal oxide film such as a capacitative insulating film having high dielectric constant, that unreacted intermediate products such as carbon (C) are significantly prevented from being incorporated into the film and that a metal oxide whose analyzed composition is similar to the stoichiometrical composition thereof can be produced by a single film-forming process, without necessity of carrying out an oxidizing process or an film-quality-improving process such as making the film denser after the film-forming process. Further, according to a film-forming method of the present invention, it is possible to form a thin film having, in terms of film quality, sufficiently small microcrystals whose crystal sizes are sufficiently even and a sufficiently flat surface after film formation.

As described above, according to a film-forming method of the present invention for forming a metal oxide film by the CVD method, the time required for carrying out the processes can be shortened because an oxidizing process and the like after the film-forming process are obviated. Further, unreacted intermediate products are less likely to be incorporated into the metal oxide film, whereby a metal oxide film whose analyzed composition is similar to the stoichiometrical composition thereof can be easily produced. Yet further, in terms of the film quality, the size of the microcrystals is made even and a thin film whose surface after film formation by microcrystallization is sufficiently flat can be formed. Thus, the present invention can provide an excellent interface, especially when the invention is applied to a semiconductor device or the like which is often used for forming a multi-layered film made of materials of different types.

### BRIEF DESCRIPTION OF THE DRAWINGS

Fig. 1 is a sectional view for showing a structure of the inside of a vacuum container of a system for forming a thin film used in a film-forming method of the present invention;
Fig. 2 is a graph showing a result of SIMS measurement of the concentrations of impurities contained in a hafnium oxide (HfO₂) film formed by an embodiment of the film-forming method of the present invention;
Fig. 3 is a graph showing a result of measurement of the electric properties of the hafnium oxide (HfO₂) film formed by an embodiment of the film-forming method of the present invention;
Fig. 4 (a) is a photograph showing a result of SEM observation of a comparative sample, which is a hafnium oxide (HfO₂) film formed by using O₂ gas;
Fig. 4 (b) is a photograph showing a result of SEM observation of a hafnium oxide (HfO₂) film formed by the film-forming method of an embodiment of the present invention;

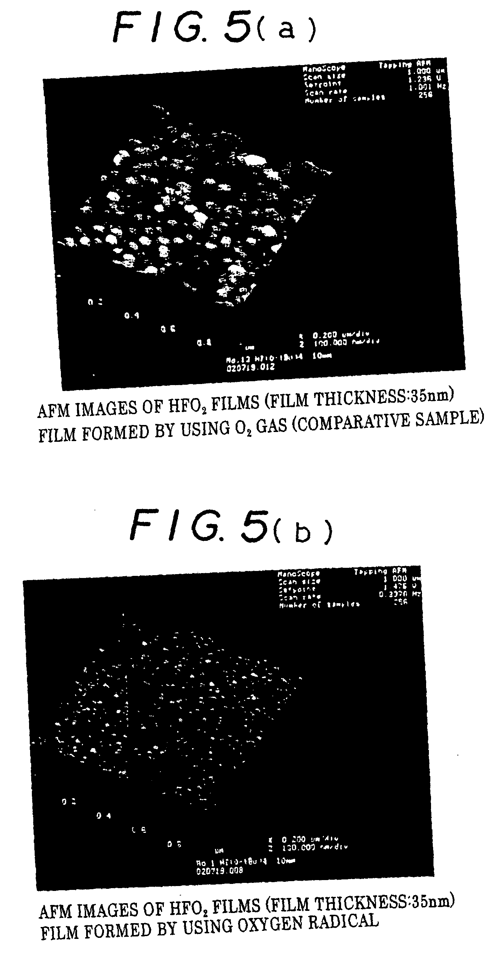

Fig. 5 (a) is a photograph showing a result of AFM observation of a comparative sample, which is a hafnium oxide (HfO₂) film formed by using O₂ gas;
Fig. 5 (b) is a photograph showing a result of AFM observation of a hafnium oxide (HfO₂) film formed by the film-forming method of an embodiment of the present invention;
Fig. 6 (a) is a photograph showing a result of AFM observation of a comparative sample, which is a ruthenium oxide (RuO₂) film formed by using O₂ gas; and
Fig. 6 (b) is a photograph showing a result of AFM observation of a ruthenium oxide (RuO₂) film formed by the film-forming method of an embodiment of the present invention.

### DETAILED DESCRIPTION OF THE INVENTION

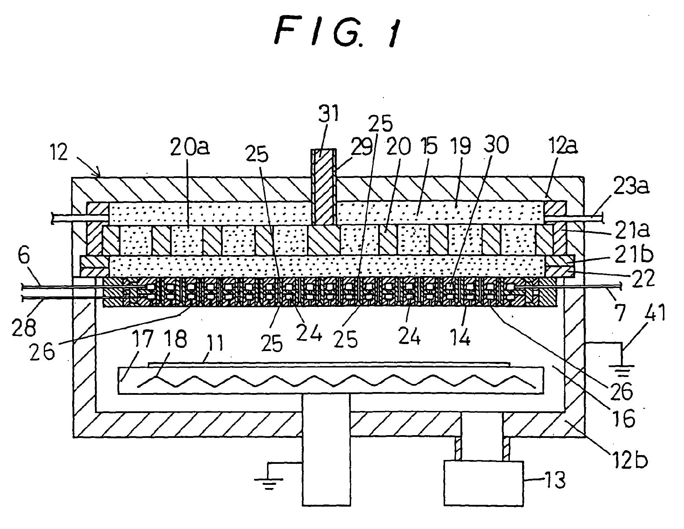

Fig. 1 shows the inside of a vacuum container of a system for forming a thin film used in the film-forming method of an embodiment of the present invention.

As shown in Fig. 1, the inside of the vacuum container 12 is partitioned to a plasma-generating space 15 and a film-forming treatment space 16 by a partition plate 14. The plasma-generating space 15 and the film-forming treatment space 16 communicate with each other only by way of a plurality of through holes 25 formed in the partition plate 14.

In the embodiment shown in Fig. 1, in terms of making the assembly property of the vacuum container 12 good, the vacuum container 12 is constituted of an upper container 12a which defines the plasma-generating space 15 and a lower container 12b which defines the film-forming treatment space 16. When the vacuum container 12 is formed by combining the upper container 12a with the lower container 12b, the partition plate 14 is provided between the upper container 12a and the lower container 12b . The partition plate 14 and the upper container 12a define the plasma-generating space 15, and the partition plate 14 and the lower container 12b define the film-forming treatment space 16.

The partition plate 14, which is made of a conductive member, has a desired thickness and a planar configuration as a whole. More precisely, the partition plate 14 has a planar form similar to a sectional shape, in the horizontal direction, of the vacuum container 12. For example, when the sectional shape, in the horizontal direction, of the vacuum container 12 is rectangular, the partition plate 14 has a rectangular sectional shape in the horizontal direction, which is similar to the sectional shape, in the horizontal direction, of the vacuum container 12. The partition plate 14 is disposed such that the periphery portions thereof are pressed by the lower-side surface of a conductive member 22 in a sealed manner. The partition plate 14 functions as an earth potential 41 by way of the conductive member 22.

Insulating members 21a and 21b are provided between an electrode 20 having a plate-like shape and the upper container 12a, such that the side surface of the periphery portion of the electrode 20 is in contact with the insulating member 21a which is the upper member of the two insulating members and lower-end surface of the periphery portion of the electrode 20 is in contact with the insulating member 21b which is the lower member of the two insulating members. A plurality of holes 20a are formed in the electrode 20.

An electricity-introducing bar 31 is provided at the ceiling portion of the upper container 12a such that the electricity-introducing bar 31 is connected with the electrode 20. High frequency electric power for discharge is supplied to the electrode 20 by the electricity-introducing bar 31. Thus, the electrode 20 functions as a high frequency electrode. The electricity-introducing bar 31 is covered with an insulting material 29, so that the electricity-introducing bar 31 is insulated from the members other than the electrode 20.

Oxygen gas is introduced into the plasma-generating space 15 of the vacuum container 12 of the system for forming a thin film, whereby oxygen radicals are generated together with oxygen plasma. The generated oxygen radicals are introduced into the film-forming treatment space 16 through the plurality of through holes 25 formed in the partition plate 14. On the other hand, an organic raw material gas is directly introduced into the film-forming treatment space 16. The oxygen radicals and the organic raw material gas each introduced as described above are reacted with each other in the film-forming treatment space 16, whereby a thin film is formed on a substrate 11.

In the partition plate 14, an inner space 24 is defined such that the inner space 24 is separated from the plasma-generating space 15 and communicates with the film-forming treatment space 16 by way of the diffusion holes 26. The organic raw material gas is first introduced into the inner space 24 inside the partition plate 14 and then directly into the film-forming treatment space 16 through the diffusion holes 26.

The system for forming a thin film described above, which uses the organic raw material gas, is provided with a mechanism which is capable of maintaining the temperature inside the partition plate 14 into which the organic raw material is introduced, at an appropriate temperature no lower than the condensation point of the organic raw material gas, so that solidification or decomposition of the gas is prevented. Specifically, a second inner space 30 which is separated from the inner space 24 is provided at the side of the plasma-generating space 15, in the partition plate 14. An inlet or outlet 6, 7 for introducing a heat-exchange medium, which medium is to flow inside the second inner space, or discharging said heat-exchange medium are provided at the partition plate 14, respectively. Examples of the heat-exchange medium which can be used include a gas or a flowable liquid such as water, air and oil.

Hereinafter, an example of a film-forming method of the present invention, which is carried out by the system for forming a thin film having the before described structure will be described.

The silicon substrate 11 is conveyed to the inside of the vacuum container 12 and disposed on a substrate-holding mechanism 17 in the vacuum container 12 by a conveyance robot (not shown) . At this process, the silicon substrate 11 is disposed such that the silicon substrate 11 is substantially in parallel with the partition plate 14 and the surface of the substrate 11 on which a thin film is to be formed (which surface is shown as the upper-side surface of the substrate in Fig. 1, and may be referred to as the "film-forming surface" hereinafter) faces the lower side of the partition plate 14.

The inside of the vacuum container 12 is evacuated by an evacuation mechanism 13 and the pressure therein is reduced to a predetermined pressure. The inside of the vacuum container 12 is maintained in such a vacuum state. Next, oxygen gas is introduced into the plasma-generating space 15 of the vacuum container 12 by way of an oxygen-introducing pipe 23a.

An organic raw material gas containing a metal element, such as hafnium-t-butoxide (the molecular formula: Hf[OC(CH₃)₃]₄) , is introduced into the inner space 24 of the partition plate 14 by way of an organic raw material gas-introducing pipe 28. As hafnium-t-butoxide exists as liquid at the room temperature, hafnium-t-butoxide is first vaporized by a vaporizer (not shown) (an organic raw material in the state in which it has been vaporized by the vaporizer will be referred to as an "organic raw material gas" hereinafter) and then introduced into the inner space 24 of the partition plate 14 by way of a pipe arrangement for the organic raw material gas (not shown) connected to the organic raw material gas-introducing pipe 28, the temperature of which pipe arrangement is to be maintained at a temperature no lower than the condensation point of the organic raw material gas in order to prevent condensation. In the present embodiment, the temperature of the partition plate 14 and that of the pipe arrangement for the organic raw material gas (not shown) are set in advance and maintained at a temperature which is higher than the condensation point of hafnium-t-butoxide. In the aforementioned process, the organic raw material gas is generally mixed with argon gas or the like as a carrier gas and then introduced into the vacuum container 12. Hafnium-t-butoxide thus prepared as the organic raw material gas is first introduced, together with argon gas as the carrier gas, into the inner space 24 and then directly into the film-forming treatment space 16 through the diffusion holes 26 without being brought into contact with plasma. The temperature of the substrate-holding mechanism 17 provided in the film-forming treatment space 16 is maintained at a predetermined temperature in advance by energizing a heater 18.

In the above-described state, electric power of high frequency is supplied to the electrode 20 through the electric power-introducing bar 31. The high frequency power causes discharge, whereby oxygen plasma 19 is generated around the electrode 20 in the plasma-generating space 15. Generation of oxygen plasma 19 results in generation of oxygen radicals (excited active species) as a neutral excited species, and the generated oxygen radicals are introduced into the film-forming treatment space 16 by way of the through holes 25. On the other hand, the organic raw material gas is introduced into the film-forming treatment space 16 by way of the inner space 24 and the diffusion holes 26 of the partition plate 14. As a result, the oxygen radical and the organic raw material gas are for the first time brought into contact with each other in the film-forming treatment space 16 and reacted with each other, whereby hafnium oxide (HfO₂) is deposited on the surface of the silicon substrate 11 and a thin film is formed thereon.

One of a preferred condition required for forming a film of hafnium-t-butoxide according to the before described example is, as follows.

| | |
|---|---|
| (1) Substrate | Silicon substrate |
| (2) High frequency power (W) | 150 |
| (3) Flow rate at which oxygen gas was introduced into the plasma-generating space (liter/sec) | 8.0 x 10⁻³ (500 sc cm) |
| (4) Flow rate of the carrier gas (argon gas) | (liter/sec) 8.0 × 10⁻⁴ (50 sc cm) |
| (5) Pressure in the plasma-generating space (Pa) | 93 |
| (6) Pressure in the space for film-forming treatment space (Pa) | 50 |
| (7) Distance between the substrate and the lower side of the partition plate (mm) | 40 |
| (8) Temperature of the silicon substrate (°C) | 370 |
| (9) Temperature of the partition plate (°C) | 90 |
| (10) Temperature of the organic raw material gas (°C) | 45 to 60 |

In order to obtain a comparative sample for comparing the effect of the film-forming method of the present invention with the effect of the conventional method, a film of hafnium oxide (HfO₂) was formed in the same film-forming conditions as described above (note that the flow rate at which oxygen gas was introduced into the plasma-generating space (liter/sec) was 8.0 × 10⁻³ (500 sc cm)), except that application of high frequency power was stopped.

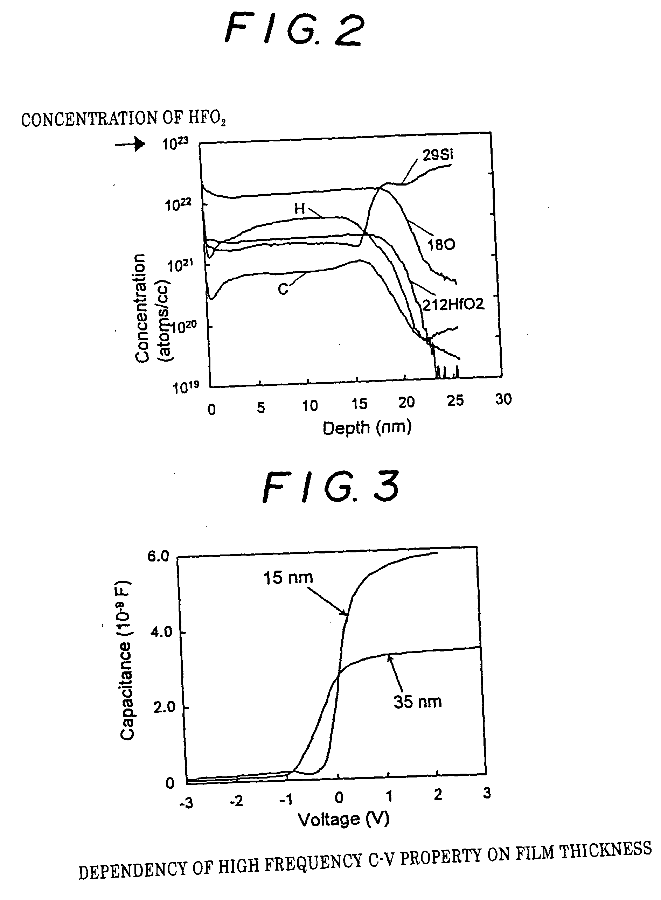

Thereafter, the concentrations of impurities such as hydrogen and carbon which remain as unreacted product in the hafniumoxide (HfO₂) filmformedbythebeforedescribedconditions were measured by SIMS (Secondary Ion Mass Spectroscopy). The result is shown in Fig. 2.

From Fig. 2, it is confirmed that the concentration of carbon as an impurity is at a very low level (0.6% or less).

Next, the electric properties were evaluated by using a MOS (Metal Oxide Semiconductor) structure, and the high frequency C-V property was measured (Fig. 3). The relative dielectric constant of the hafnium oxide (HfO₂) film was calculated from the thus obtained results. The calculated relative dielectric constant was approximately 22, which was satisfactory.

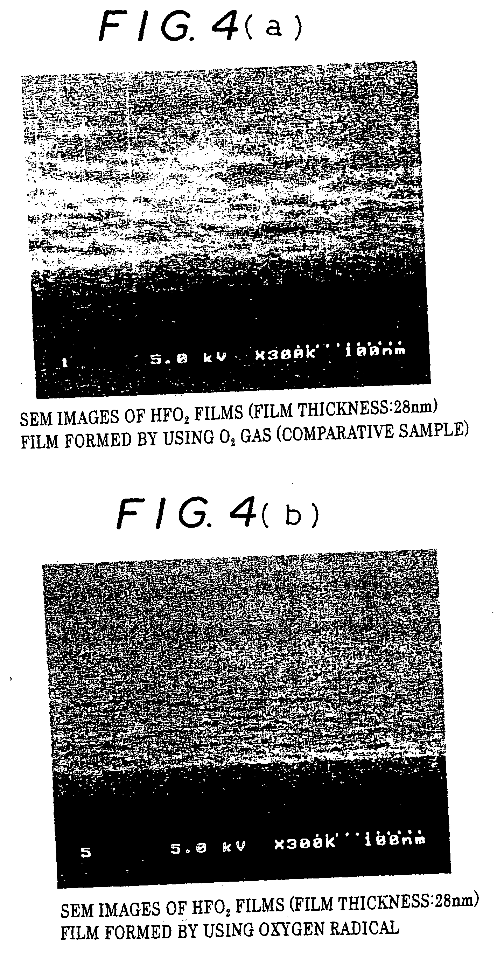

Finally, the hafnium oxide (HfO₂) film obtained in the above-described conditions according to the film-forming method of the present invention and the film formed on the surface of the comparative sample were each observed by a SEM (Scanning Electron Microscope) and an AFM (Atomic Force Microscope) (refer to Fig. 4).

From the SEM observation (× 300, 000) , it is confirmed that the hafnium oxide film formed by using oxygen radical according to the film-forming method of the present invention exhibits significantly improved smoothness of the film surface, i.e. , less significant irregularities at the surface, as compared with the hafnium oxide film formed by using oxygen gas in place of oxygen radical.

The above-described fact is also confirmed from the result of the AMF measurement in which the surface roughness (Ra) of the hafnium oxide film of the present invention (1 nm) is significantly lower than that of the comparative sample (3 nm) .

Accordingly, the present invention can provide an excellent interface, especially when the invention is applied to a semiconductor device which is often used for forming a multi-layered film made of materials of different types.

Examples of the organic raw material gas containing a metal element include, in addition to hafnium-t-butoxide (the molecular formula thereof is Hf [OC(CH₃)₃]₄) , tetra-i-propoxy titaium (the molecular formula thereof is Ti [OCH(CH₃)₂]₄), bis(ethylcyclopentadienyl) ruthenium (the molecular formula thereof is Ru(C₂H₅C₅H₄) ₂) , penta-i-propoxy tantalum (the molecular formula thereof is Ta[O-i-C₃H₇)]5), tetra-i-propoxy zirconium (the molecular formula thereof is Zr [O-i-C₃H₇)]₄), and tri-sec-butoxy aluminum (the molecular formula thereof is Al[O-sec-C₄H₉)] ₃) . By using each of the aforementioned examples of the organic raw material gas and carrying out the film-forming method of the present invention in the same manner as described above, atitaniumoxide (TiO₂) film, arutheniumoxide (RuO₂) film, a tantalum oxide (Ta₂O₃) film, a zirconium oxide (ZrO₂) film and an aluminum oxide (Al₂O₃) film were formed, respectively. For the respective metal oxide films, an effect as good as that of the hafnium oxide film described above was confirmed.

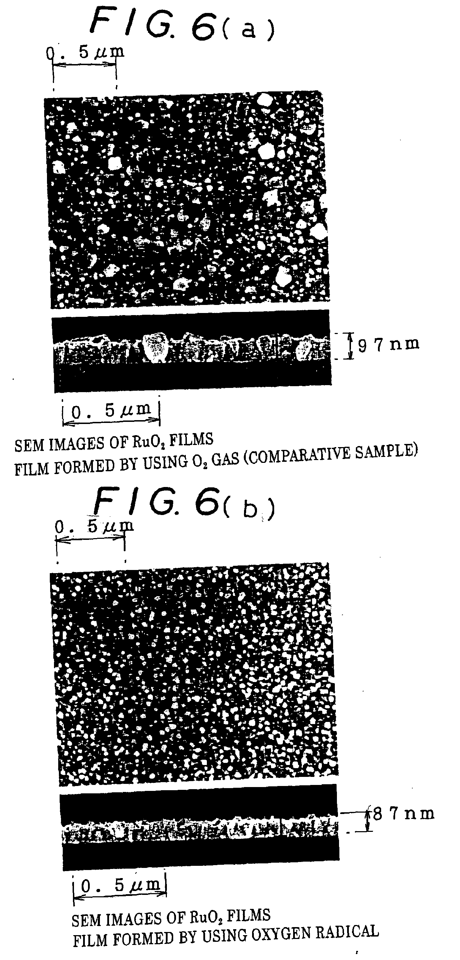

Fig. 6 (a) shows the result of the AFM observation in a case in which a ruthenium oxide (RuO₂) film was formed by using oxygen gas in place of oxygen radicals and using bis(ethylcyclopentadienyl) ruthenium (the molecular formula thereof is Ru(C₂H₅C₅H₄)₂) as the organic raw material containing a metal element.

Fig. 6 (b) shows the result of the AFM observation in a case in which a ruthenium oxide (RuO₂) film was formed according to the film-forming method of the present invention by using bis(ethylcyclopentadienyl) ruthenium (the molecular formula thereof is Ru(C₂H₅C₅H₄)₂) as the organic raw material containing a metal element.

One of a preferred film-forming condition of the ruthenium oxide (RuO₂) film shown in Fig. 6(b) is, as follows.

| | |
|---|---|
| (1) Substrate | Silicon substrate |
| (2) High frequency power (W) | 200 |
| (3) Flow rate at which oxygen gas was introduced into the plasma-generating space (liter/sec) | 8.0 × 10⁻³ (500 sc cm) |
| (4) Flow rate of the carrier gas (argon gas) (liter/sec) | 8.0 × 10⁻⁴ (50 sc cm) |
| (5) Pressure in the plasma-generating space (Pa) | 93 |
| (6) Pressure in the film-forming treatment space (Pa) | 50 |
| (7) Distance between the substrate and partition plate (mm) | the lower side of the 40 |
| (8) Temperature of the silicon substrate (°C) | 325 |
| (9) Temperature of the partition plate (°C) | 90 |
| (10) Temperature of the organic raw material gas (°C) | 45 to 60 |

In order to obtain a comparative sample for comparing the effect of the film-forming method of the present invention with the effect of the conventional method, a film of ruthenium oxide (RuO₂) was formed in the same film-forming conditions as described above (note that the flow rate at which oxygen gas was introduced into the plasma-generating space (liter/sec) was 8.0 × 10⁻³ (500 sc cm)), except that application of high frequency power was stopped. The result of SEM observation of the thus obtained ruthenium oxide (RuO₂) film of the comparative sample is shown in Fig. 6(a).

The upper images shown in Figs. 6(a) and 6(b) are each an image viewed from a position right above the film surface. From these images, it is confirmed that the film shown in Fig. 6(b) formed by the film-forming method of the present invention has significantly smaller microcrystals than the film shown in Fig. 6(a). It is also confirmed that the crystal size of the film shown in Fig. 6(b) is more even than that of the film shown in Fig. 6(a).

The lower images shown in Figs. 6 (a) and 6 (b) are sections of the comparative sample and the sample obtained by the film-forming method ofthe presentinvention,respectively. From these images, it is confirmed that the film shown in Fig. 6(b) exhibits a decreased surface roughness, as compared with the film shown in Fig. 6(a).

The present invention is not limited to the preferable embodiments of the present invention described above, and may be modified to various embodiments within the technological scope defined by the descriptions of the accompanying claims and equivalents thereof.

## Claims

1. A film-forming method comprising:
introducing oxygen radicals and an organic raw material gas containing a metal element into a vacuum container; and
reacting the organic raw material gas with the oxygen radicals, thereby forming a metal oxide film on a surface of a substrate disposed in the vacuum container.

2. The film-forming method according to claim 1,wherein
the organic raw material gas and the oxygen radicals are for the first time brought into contact with each other in the vacuum container.

3. The film-forming method according to claim 1 or 2, whererin
the oxygen radicals and the organic raw material gas containing a metal element are introduced into a film-forming treatment space in the vacuum container by way of a plurality of injection holes, and the organic raw material gas is reacted with the oxygen radicals in the film-forming treatment space, thereby a metal oxide film is formed on the surface of the substrate;
said film-forming treatment space is defined in the vacuum container by a space between a substrate disposed in the vacuum container and a plurality of injection holes disposed to face said substrate.

4. The film-forming method according to claim 3, whererin
the oxygen radicals are generated in a plasma generating space in a vacuum container, and said generated oxygen radicals and the organic raw material gas containing a metal element are introduced into a film-forming treatment space in the vacuum container by way of a plurality of injection holes.

5. A film-forming method according to any one of claims 1 to 4, wherein ametal element contained in the organic rawmaterial gas is selected from the group consisting of ruthenium, hafnium, titanium, tantalum, zirconium and aluminum.
